# EUROPEAN PATENT APPLICATION

(11) **EP 3 985 820 A1**
(43) Date of publication of application: **20.04.2022**
(21) Application number: 20905309.9
(22) Date of filing: 19.05.2020
(51) Int. Cl.: H02H 11/00

(54) **POWER-ON/OFF CIRCUIT FOR BATTERY MANAGEMENT SYSTEM**

(30) Priority: 26.12.2019 CN 201911365101; 26.12.2019 CN 201922379646 U
(71) Applicant: Pylon Technologies, Co. Ltd, Shanghai 201203 (CN)
(72) Inventor: WANG, Hongxing, Shanghai 201203 (CN); SHI, Lu, Shanghai 201203 (CN); LI, Fanjun, Shanghai 201203 (CN); YAO, Bin, Shanghai 201203 (CN)
(74) Representative: Rossi, Ugo
(86) International application number: PCT/CN2020/091103
(87) International publication number: WO 2021/128714

(57) **Abstract**

The present invention discloses a switch on/off circuit for a battery management system, including a driving signal input terminal, a start-up driving signal output terminal, a power supply terminal, a power signal extraction circuit, a trigger circuit, and a switch. The driving signal input terminal is connected to the start-up driving signal output terminal by the switch. The power signal extraction circuit is connected to the power supply terminal, and is configured to output a control signal based on a power signal inputted from the power supply terminal. The trigger circuit is electrically connected to the power signal extraction circuit. The trigger circuit is configured to control the switch on or off according to a transition of the control signal. The switch on/off circuit for a battery management system provided in the present invention, by using the trigger circuit to receive the switch on/off signal outputted by the power signal extraction circuit, realizes the unified management of switch on and off signals. The switch on/off circuit is easy to expand and has high reusability.

## Description

### TECHNICAL FIELD

Embodiments of the present invention relate to power electronic technologies, and in particular, to a switch on/off circuit for a battery management system.

### BACKGROUND

A battery management system (BMS), as a link between batteries and users, is mainly oriented to secondary batteries. The BMS is mainly to improve the utilization of the battery and prevent the battery from over-charging and over-discharging.

In battery management related products in the prior art, in order to realize the switch on/off control of the BMS such as short press start-up and protection for reverse connection of the power supply, a microcontroller unit (MCU) is usually used to control switch on and off signals. However, the MCU needs to be programmed with a corresponding control program and needs to be debugged many times, wasting time and manpower. The expensive MCU also leads to an increase in the costs. A switch on/off circuit designed based on the MCU is not easy to expand and has poor reusability.

Therefore, there is an urgent need for a switch on/off circuit with low costs, high reusability and protection for reverse connection, which can avoid short circuit of the system due to reverse connection of the power supply when the BMS is activated.

### SUMMARY

The present invention provides a switch on/off circuit for a battery management system which features small loss and low costs and is easy to expand.

An embodiment of the present invention provides a switch on/off circuit for a battery management system, including a driving signal input terminal, a start-up driving signal output terminal, a power supply terminal, a power signal extraction circuit, a trigger circuit and a switch; the driving signal input terminal being connected to the start-up driving signal output terminal by the switch; the power signal extraction circuit being connected to the power supply terminal, and being configured to output a control signal based on a power signal inputted from the power supply terminal; and the trigger circuit being electrically connected to the power signal extraction circuit, and being configured to control the switch on or off according to a transition of the control signal.

Further, the power signal extraction circuit includes a first optocoupler device and a second optocoupler device; the power supply terminal includes a power positive terminal and a power negative terminal, the power positive terminal and the power negative terminal are respectively electrically connected to a first terminal and a second terminal of the first optocoupler device, and the power positive terminal and the power negative terminal are respectively electrically connected to a second terminal and a first terminal of the second optocoupler device; the trigger circuit includes a first signal trigger terminal and a second signal trigger terminal, a third terminal of the first optocoupler device is electrically connected to the driving signal input terminal and the first signal trigger terminal, a fourth terminal of the first optocoupler device is grounded, and the first optocoupler device is configured to output the control signal for controlling the switch on, and a third terminal of the second optocoupler device is electrically connected to a high-level signal terminal, a fourth terminal of the second optocoupler device is grounded through a first resistor, the fourth terminal of the second optocoupler device is electrically connected to the second signal trigger terminal, and the second optocoupler device is configured to output the control signal for controlling the switch off.

Further, the switch on/off circuit further includes a reverse signal output terminal and a first metal-oxide-semiconductor (MOS) transistor, where the fourth terminal of the second optocoupler device is electrically connected to a control terminal of the first MOS transistor, a first terminal of the first MOS transistor is electrically connected to the reverse signal output terminal, and a second terminal of the first MOS transistor is grounded.

Further, the trigger circuit includes a second MOS transistor, a third MOS transistor, a Schmidt trigger, a D-type flip-flop and a fourth MOS transistor; the third terminal of the first optocoupler device is electrically connected to a control terminal of the second MOS transistor, a first terminal of the second MOS transistor is electrically connected to an input terminal of the Schmidt trigger, and a second terminal of the second MOS transistor is grounded; the fourth terminal of the second optocoupler device is electrically connected to a control terminal of the third MOS transistor, a first terminal of the third MOS transistor is electrically connected to a reset terminal of the D-type flip-flop, and a second terminal of the third MOS transistor is grounded; and an output terminal of the D-type flip-flop is electrically connected to a control terminal of the fourth MOS transistor, a first terminal of the fourth MOS transistor is electrically connected to the switch, and a second terminal of the fourth MOS transistor is grounded.

Further, the switch on/off circuit further includes an auxiliary shutdown circuit, where the auxiliary shutdown circuit includes an input terminal, an output terminal and an auxiliary shutdown signal terminal; and the input terminal of the auxiliary shutdown circuit is electrically connected to the start-up driving signal output terminal, the output terminal of the auxiliary shutdown circuit is electrically connected to the reset terminal of the D-type flip-flop, and the auxiliary shutdown circuit is configured to output the control signal for controlling the switch off according to a signal inputted from the auxiliary shutdown signal terminal.

Further, the auxiliary shutdown circuit includes a triode, a third resistor, a first capacitor and a fifth MOS transistor; a control terminal of the triode is electrically connected to the auxiliary shutdown signal terminal, a first terminal of the triode is electrically connected to the start-up driving signal output terminal, the third resistor is connected in parallel to the first capacitor, a second terminal of the triode is grounded through the third resistor, and the second terminal of the triode is electrically connected to a control terminal of the fifth MOS transistor; and a first terminal of the fifth MOS transistor is electrically connected to the reset terminal of the D-type flip-flop, and a second terminal of the fifth MOS transistor is grounded.

Further, the auxiliary shutdown circuit further includes a fourth resistor, a fifth resistor, a sixth resistor and a seventh resistor, the start-up driving signal output terminal is electrically connected to the first terminal of the triode through the fourth resistor; the start-up driving signal output terminal is electrically connected to the control terminal of the triode through the fifth resistor, the auxiliary shutdown signal terminal is electrically connected to the control terminal of the triode through the sixth resistor, and the second terminal of the triode is electrically connected to the control terminal of the fifth MOS transistor through the seventh resistor.

Further, the switch on/off circuit further includes an emergency start circuit, where the emergency start circuit includes a key switch, a first terminal of the key switch is grounded, and a second terminal of the key switch is electrically connected to the control terminal of the second MOS transistor.

Further, the second terminal of the key switch is electrically connected to the control terminal of the second MOS transistor through an eighth resistor.

Further, the power positive terminal is electrically connected to the first terminal of the first optocoupler device by a first diode, and the power negative terminal is electrically connected to the first terminal of the second optocoupler device by a second diode;
a third diode is connected in parallel between the power positive terminal and the power negative terminal, and the power positive terminal is electrically connected to the first terminal of the first optocoupler device by a first inductor; and
the power positive terminal is electrically connected to the power negative terminal by a ninth resistor and a tenth resistor, and the power positive terminal is electrically connected to the first terminal of the first optocoupler device by the ninth resistor.

The switch on/off circuit for a battery management system provided in the present invention, by using the trigger circuit to receive the switch on/off signal outputted by the power signal extraction circuit, realizes the unified management of switch on and off signals. The switch on/off circuit is easy to expand and has high reusability.

### BRIEF DESCRIPTION OF THE DRAWINGS

FIG. 1 shows a switch on/off circuit for a battery management system in an embodiment;
FIG. 2 shows another switch on/off circuit for a battery management system in an embodiment;
FIG. 3 shows still another switch on/off circuit for a battery management system in an embodiment;
FIG. 4 shows still another switch on/off circuit for a battery management system in an embodiment; and
FIG. 5 shows still another switch on/off circuit for a battery management system in an embodiment.

### DETAILED DESCRIPTION

The present invention is further described in detail with reference to the drawings and embodiments. It can be understood that the specific embodiments described herein are only used for explaining the present invention, and are not intended to limit the present invention. In addition, it should be noted that for the convenience of description, only some but not all structures related to the present invention are shown in the drawings.

### Embodiment 1

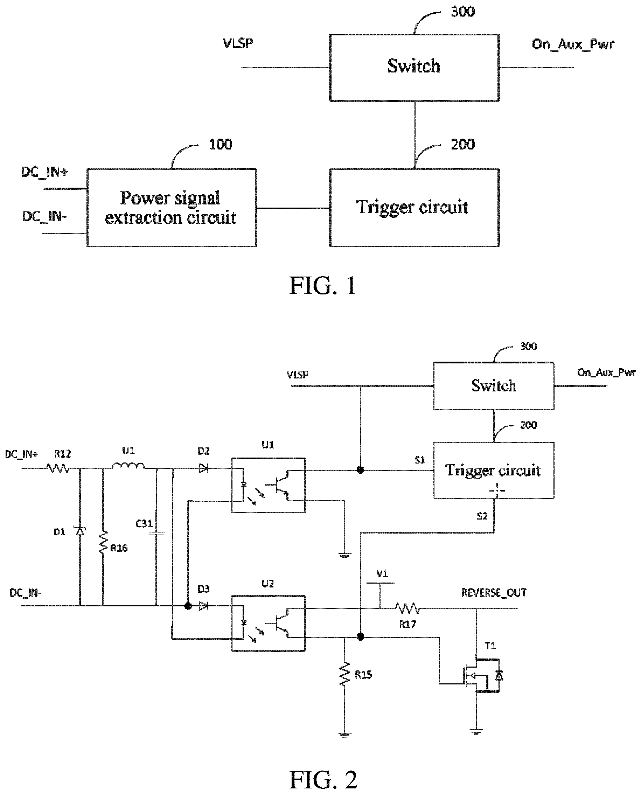

FIG. 1 shows a switch on/off circuit for a battery management system in an embodiment. Referring to FIG. 1, the switch on/off circuit includes a driving signal input terminal VSLP and a start-up driving signal output terminal On_Aux_Pwr, power supply terminals DC_IN+ and DC_IN-, a power signal extraction circuit 100, a trigger circuit 200 and a switch 300.

The driving signal input terminal VSLP is connected to the start-up driving signal output terminal On_Aux_Pwr by the switch 300. The power signal extraction circuit 100 is connected to the power supply terminals DC_IN+ and DC_IN-, and is configured to output a control signal based on a power signal inputted from the power supply terminals DC_IN+ and DC_IN-. The trigger circuit 200 is electrically connected to the power signal extraction circuit 100. The trigger circuit 200 is configured to control the switch 300 on or off according to a transition of the control signal.

In this embodiment, the start-up driving signal output terminal On_Aux_Pwr is electrically connected to a power supply of the battery management system, and the power signal extraction circuit 100 is connected to the power supply terminals DC_IN+ and DC_IN-. When the power supply terminals are normally connected, the power signal extraction circuit 100 outputs a first control signal for controlling the switch 300 on to the trigger circuit 200. After the switch 300 is on, the start-up driving signal output terminal On_Aux_Pwr outputs a high-level signal to the power supply, so that the power supply starts up, and the battery management system starts up. When the power supply terminals are reversely connected, the power signal extraction circuit 100 outputs a second control signal for controlling the switch 300 off to the trigger circuit 200. After the switch 300 is off, the start-up driving signal output terminal On_Aux_Pwr outputs a low-level signal to the power supply, so that the power supply shuts down, and the battery management system shuts down.

In this embodiment, the driving signal input terminal VSLP provides a 3.0-5.5 V voltage signal, and low-power low-dropout regulator (LDO), such as TPS7233, may be used to generate an input voltage of the driving signal input terminal VSLP, so that the static power consumption of the circuit is less than 30 µA. The power signal extraction circuit 100 is powered by the voltage inputted from the power supply terminals, and does not consume the current from the low-power LDO.

For example, the switch 300 includes a MOS transistor, a triode, and a relay. Specifically, a control terminal of the switch 300 is electrically connected to an output terminal of the trigger circuit 200, a first terminal of the switch 300 is electrically connected to the driving signal input terminal VSLP, and the first terminal of the switch 300 is electrically connected to the start-up driving signal output terminal On_Aux_Pwr.

For example, the power signal extraction circuit 100 may include an optocoupler device, an input terminal of the optocoupler device is electrically connected to a power supply terminal, and a collector of a phototransistor in the optocoupler device is used as a control signal output terminal. When the power supply terminals are normally connected, the optocoupler device is on, and a level signal of the collector of the phototransistor is a control signal to be outputted to the trigger circuit 200 for controlling the switch 300 on. When the power supply terminals are reversely connected, the optocoupler device is off, and a level signal of the collector of the phototransistor is a control signal to be outputted to the trigger circuit 200 for controlling the switch 300 off. The power signal extraction circuit may further include a MOS transistor, for example, an NMOS transistor. In this case, the NMOS transistor is connected in series in the power circuit, and a gate of the NMOS transistor is electrically connected to the power supply terminal DC_IN+ by a resistor. When the power supply terminals are normally connected, the NMOS transistor is on, and a level signal of a drain of the NMOS transistor is used as a control signal to be outputted to the trigger circuit 200 for controlling the switch 300 on. When the power supply terminals are reversely connected, the NMOS transistor is off, and a level signal of the drain of the NMOS transistor is used as a control signal to be outputted to the trigger circuit 200 for controlling the switch 300 off. The trigger circuit 200 may include a NAND gate device, for example, an AND gate 74LS08. One input terminal of the AND gate is connected to a reference level, the other input terminal is electrically connected to the output terminal of the power signal extraction circuit 100, and an output terminal of the AND gate is electrically connected to the control terminal of the switch 300.

For example, the power signal extraction circuit 100 may further include a plurality of optocoupler devices, for example, two optocoupler devices. Input terminals of the two optocoupler devices are connected in the opposite way to the power supply terminals DC_IN+ and DC_IN-. In this way, when the power supply terminals are normally connected, a control signal for controlling the switch 300 on is outputted from one of the optocoupler devices to the trigger circuit 200, and when the power supply terminals are reversely connected, a control signal for controlling the switch 300 off is outputted from the other optocoupler device to the trigger circuit 200.

The trigger circuit 200 may further include a Schmidt trigger and a D-type flip-flop. An output terminal of the Schmidt trigger is electrically connected to a clock terminal of the D-type flip-flop, an output terminal of the D-type flip-flop is electrically connected to the control terminal of the switch 300, a collector of the optocoupler device which is configured to output a signal for switching on the switch 300 is electrically connected to an input terminal of the Schmidt trigger, and an emitter of the optocoupler device which is configured to output a signal for switching off the switch 300 is electrically connected to a reset terminal of the D-type flip-flop. When the conduction status of the optocoupler device changes, the Schmidt trigger outputs a rising edge signal to the D-type flip-flop, and then the D-type flip-flop outputs a signal for controlling the switch 300 on or off.

The switch on/off circuit provided in this embodiment uses the trigger circuit 200 to receive a switch on/off signal outputted by the power signal extraction circuit 100, where devices used in the trigger circuit 200 include a NAND gate device, a Schmidt trigger, or a D-type flip-flop. During the design of the circuit, the signal outputted from the power signal extraction circuit 100 is inputted to an input pin of the foregoing device. Whereby, the unified management of switch on and off signals is realized. In addition, the switch on/off circuit is easy to expand. For example, other control signals such as a switch on/off control signal of the outputted from an external control circuit may be directly inputted to the input pin of the foregoing device to expand the functions of the switch on/off circuit. Also, the switch on/off circuit requires low overall design costs and has high reusability.

FIG. 2 shows another switch on/off circuit for a battery management system in an embodiment. Referring to FIG. 2, preferably, the power signal extraction circuit 100 includes a first optocoupler device U1 and a second optocoupler device U2, the power supply terminals include a power positive terminal DC_IN+ and a power negative terminal DC_IN-, the power positive terminal DC_IN+ and the power negative terminal DC_IN- are electrically connected to a first terminal and a second terminal of the first optocoupler device U1 respectively, and the power positive terminal DC_IN+ and the power negative terminal DC_IN- are electrically connected to a second terminal and a first terminal of the second optocoupler device U2 respectively. The trigger circuit 200 includes a first signal trigger terminal S1 and a second signal trigger terminal S2. A third terminal of the first optocoupler device U1 is electrically connected to the driving signal input terminal VSLP and the first signal trigger terminal S1. A fourth terminal of the first optocoupler device U1 is grounded. The first optocoupler device U1 is configured to output a control signal for controlling the switch 300 on. A third terminal of the second optocoupler device U2 is electrically connected to a high-level signal terminal V1. A fourth terminal of the second optocoupler device U2 is grounded through a first resistor R15. The fourth terminal of the second optocoupler device U2 is electrically connected to the second signal trigger terminal S2. The second optocoupler device U2 is configured to output a control signal for controlling the switch 300 off.

The power signal extraction circuit 100 shown in FIG. 2 includes two optocoupler devices. When the power supply terminals are normally connected, the first optocoupler device U1 is on and the second optocoupler device U2 is off. When U1 is on, the first signal trigger terminal S1 changes from high level to low level, and the trigger circuit 200 receives, through the first signal trigger terminal S1, a control signal outputted by the first optocoupler device U1. When the power supply terminals are reversely connected, the first optocoupler device U1 is off and the second optocoupler device U2 is on. When U2 is on, the second signal trigger terminal S2 changes from low level to high level, and the trigger circuit 200 receives, through the second signal trigger terminal S2, a control signal outputted by the second optocoupler device U2. For example, the trigger circuit 200 is implemented using an AND gate device, and the switch 300 is implemented using a PMOS transistor. A reference terminal of the AND gate device is connected to a high level, an input terminal of the AND gate device is electrically connected to the first signal trigger terminal S1 and the second signal trigger terminal S2, and an output terminal of the AND gate device is electrically connected to a control terminal of the PMOS transistor. When the first optocoupler device U1 is on, the input terminal of the AND gate device is at a low level, and the output terminal of the AND gate device outputs a low level. In this case, the PMOS transistor is on, and the start-up driving signal output terminal On_Aux_Pwr outputs a high level signal to the power supply, so that the power supply starts up, and the battery management system starts up. When the second optocoupler device U2 is on, the input terminal of the AND gate device is at a high level, and the output terminal of the AND gate device outputs a high level. In this case, the PMOS transistor is off, and the start-up driving signal output terminal On_Aux_Pwr outputs a low level signal to the power supply, so that the power supply shuts down, and the battery management system shuts down.

Referring to FIG. 2, optionally, the switch on/off circuit further includes a reverse signal output terminal REVERSE_OUT and a first MOS transistor T1. The fourth terminal of the second optocoupler device U2 is electrically connected to a control terminal of the first MOS transistor T1, a first terminal of the first MOS transistor T1 is electrically connected to the reverse signal output terminal REVERSE_OUT, and a second terminal of the first MOS transistor T1 is grounded.

When the second optocoupler device U2 is on, a level at a gate of the first MOS transistor T1 changes from low to high, the first MOS transistor T1 is on, and a level at the reverse signal output terminal REVERSE_OUT changes from high to low. Based on the change of the level at the reverse signal output terminal REVERSE_OUT, it can be detected whether the power supply terminals are reversely connected.

Referring to FIG. 2, preferably, the power positive terminal DC_IN+ is electrically connected to the first terminal of the first optocoupler device U1 by a first diode D2, the power negative terminal DC_IN- is electrically connected to the first terminal of the second optocoupler device U2 by a second diode D3, a third diode D1 is connected in parallel between the power positive terminal DC_IN+ and the power negative terminal DC_IN-, the power positive terminal DC_IN+ is electrically connected to the first terminal of the first optocoupler device U1 by a ninth resistor R12 and a first inductor L1, and the power positive terminal DC_IN+ is electrically connected to the power negative terminal DC_IN- by the ninth resistor R12 and a tenth resistor R16.

The optocoupler device is used to realize the voltage isolation between the signal extraction circuit, the trigger circuit 200, and the switch 300, and is used together with the third diode D1 and the first inductor L1 to form a lightning protection structure to absorb surges generated by lightning. Through the ninth resistor R12, the tenth resistor R16, the first diode D2, and the second diode D3, the voltage inputted to the first optocoupler device U1 and the second optocoupler device U2 can be stabilized.

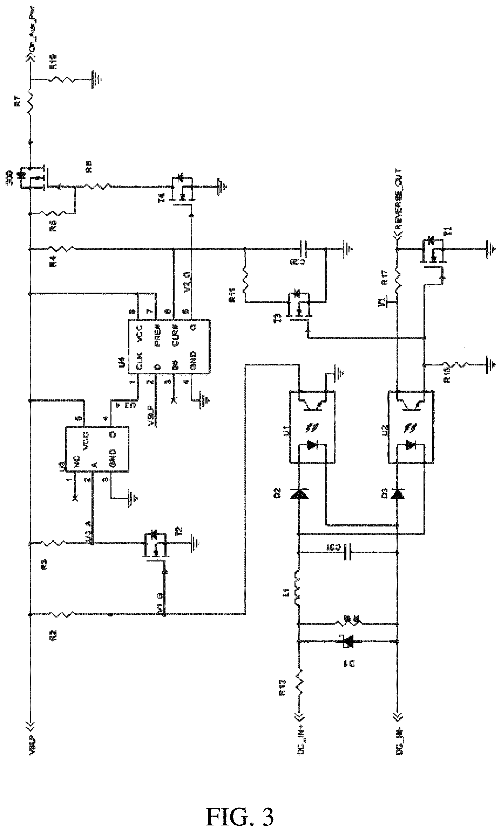

FIG. 3 shows still another switch on/off circuit for a battery management system in an embodiment. Referring to FIG. 3, preferably, the trigger circuit 200 includes a second MOS transistor T2, a third MOS transistor T3, a Schmidt trigger U3, a D-type flip-flop U4, and a fourth MOS transistor T4. The third terminal of the first optocoupler device U1 is electrically connected to a control terminal of the second MOS transistor T2, a first terminal of the second MOS transistor T2 is electrically connected to an input terminal A of the Schmidt trigger U3, and a second terminal of the second MOS transistor T2 is grounded. The fourth terminal of the second optocoupler device U2 is electrically connected to a control terminal of the third MOS transistor T3, a first terminal of the third MOS transistor T3 is electrically connected to a reset terminal CLR# of the D-type flip-flop U4, and a second terminal of the third MOS transistor T3 is grounded. An output terminal Q of D-type flip-flop U4 is electrically connected to a control terminal of the fourth MOS transistor, a first terminal of the fourth MOS transistor T4 is electrically connected to the switch 300, and a second terminal of the fourth MOS transistor T4 is grounded. The second MOS transistor T2, the third MOS transistor T3, and the fourth MOS transistor T4 are NMOS transistors, and the switch 300 is a PMOS transistor.

Referring to FIG. 3, in an initial state, there is no voltage at the power supply terminals, the optocoupler device is not on, a point V1_G in the circuit is at a high level, a point U3_A is at a low level, and an output terminal O of the Schmidt trigger U3 is at a low level. When the power supply terminals are normally connected, the first optocoupler device U1 is on, the level of V1_G is pulled down, the second MOS transistor T2 is off, and the potential at the point U3_A has a transition from 0 to 1. The signal is shaped by the Schmidt trigger U3 to generate a steep rising edge level, and the level signal is outputted to the D-type flip-flop U4, which is equivalent to transmitting a clock signal to the D-type flip-flop U4. The output terminal Q of the D-type flip-flop U4 outputs a high level, the fourth MOS transistor T4 is on, the switch 300 is on, and the VSLP voltage is fed to the On_Aux_Pwr signal terminal to activate the power supply of the system. When the power supply terminals are reversely connected, the second optocoupler device U2 is on, the level at the gate of the third MOS transistor T3 changes from low to high, the third MOS transistor T3 is on, the level at the reset terminal CLR# of the D-type flip-flop U4 is pulled down, and the output terminal Q of the D-type flip-flop U4 outputs a low level, so that the fourth MOS transistor T4 is off, the switch 300 is off, and the system power shuts down.

By using the Schmidt trigger to extract the rising edge signal generated when the power supply terminals are normally connected, power-on activation is realized, thereby improving the stability of the switch on/off circuit.

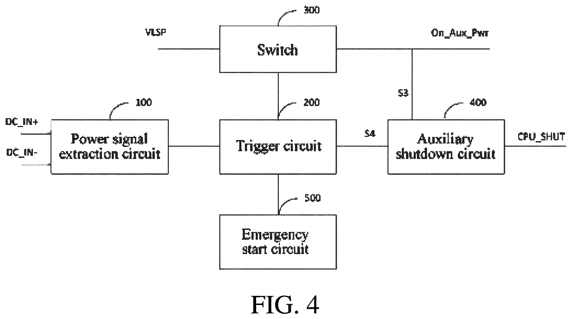

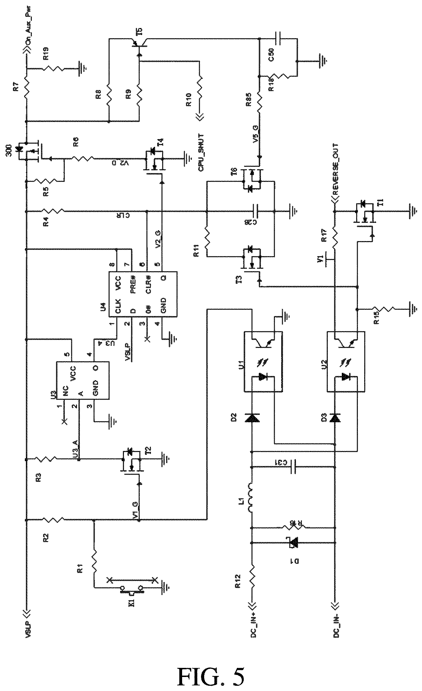

FIG. 4 shows still another switch on/off circuit for a battery management system in an embodiment, and FIG. 5 shows still another switch on/off circuit for a battery management system in an embodiment. Referring to FIG. 4 and FIG. 5, optionally, the switch on/off circuit further includes an auxiliary shutdown circuit 400. The auxiliary shutdown circuit 400 includes an input terminal S3, an output terminal S4, and an auxiliary shutdown signal terminal CPU_SHUT. The input terminal S3 of the auxiliary shutdown circuit 400 is electrically connected to the start-up driving signal output terminal On_Aux_Pwr. The output terminal S4 of the auxiliary shutdown circuit 400 is electrically connected to the trigger circuit 200, to be specific, electrically connected to the reset terminal CLR# of the D-type flip-flop U4. The auxiliary shutdown circuit 400 is configured to output a control signal for controlling the switch 300 off according to a signal inputted from the auxiliary shutdown signal terminal CPU_SHUT.

Referring to FIG. 5, specifically, the auxiliary shutdown circuit 400 includes a triode T5, a third resistor R18, a first capacitor C50, and a fifth MOS transistor T6. A control terminal of the triode T5 is electrically connected to the auxiliary shutdown signal terminal CPU_SHUT, a first terminal of the triode T5 is electrically connected to the start-up driving signal output terminal On_Aux_Pwr, the third resistor R18 is connected in parallel to the first capacitor C50, a second terminal of the triode T5 is grounded through the third resistor R18, the second terminal of the triode is electrically connected to a control terminal of the fifth MOS transistor, a first terminal of the fifth MOS transistor T6 is electrically connected to the reset terminal CLR# of the D-type flip-flop U4, and a second terminal of the fifth MOS transistor T6 is grounded. The triode T5 is a PNP transistor, and the fifth MOS transistor T6 is an NMOS transistor.

An external shutdown signal is inputted from the auxiliary shutdown signal terminal CPU_SHUT. When the inputted level is a low level, the triode T5 is on, a point V5_G is at a high level, the fifth MOS transistor T6 is on, the level at the reset terminal CLR# of the D-type flip-flop U4 is pulled down, and the output terminal Q of the D-type flip-flop U4 outputs a low level, so that the fourth MOS transistor T4 is off, the switch 300 is off, and the system power shuts down.

Referring to FIG. 5, optionally, the auxiliary shutdown circuit 400 further includes a fourth resistor R8, a fifth resistor R9, a sixth resistor R10, and a seventh resistor R85. The start-up driving signal output terminal On_Aux_Pwr is electrically connected to a first terminal of the triode T5 by the fourth resistor R8, the start-up driving signal output terminal On_Aux_Pwr is electrically connected to a control terminal of the triode T5 by the fifth resistor R9, the auxiliary shutdown signal terminal CPU_SHUT is electrically connected to the control terminal of the triode T5 by the sixth resistor R10, and a second terminal of the triode T5 is electrically connected to the control terminal of the fifth MOS transistor T5 by the seventh resistor R85. The fourth resistor R8 and the fifth resistor R9 are used as current limiting resistors, the sixth resistor R10 is used as a pull-down resistor, and the seventh resistor R85 is used as a pull-up resistor.

Referring to FIG. 4 and FIG. 5, the switch on/off circuit further includes an emergency start circuit 500. The emergency start circuit 500 includes a key switch K1. A first terminal of the key switch K1 is grounded, and a second terminal of the key switch K1 is electrically connected to the control terminal of the second MOS transistor T2.

The emergency start circuit 500 is configured for a scenario where no voltage is inputted to the power supply terminals. In special emergency situations, the power supply of the system can be started by using the key switch K1. When the key switch K1 is closed, the level at V1_G is pulled down, the second MOS transistor T2 is off, and the potential at the point U3_A has a transition from 0 to 1. The signal is shaped by the Schmidt trigger U3 to generate a steep rising edge level, and the level signal is outputted to the D-type flip-flop U4, which is equivalent to transmitting a clock signal to the D-type flip-flop U4. The output terminal Q of the D-type flip-flop U4 outputs a high level, the fourth MOS transistor T4 is on, the switch 300 is on, and the VSLP voltage is fed to the On_Aux_Pwr signal terminal to activate the power supply of the system.

Preferably, the second terminal of the key switch K1 is electrically connected to the control terminal of the second MOS transistor T2 by the eighth resistor R1. By using the eighth resistor R1, the anti-interference ability of the second MOS transistor T2 is improved.

It should be noted that the foregoing description is merely preferred embodiments of the present invention and the technical principles adopted. It will be understood by those skilled in the art that the present invention is not limited to the specific embodiments described herein. For those skilled in the art, various obvious changes, readjustments, and replacements can be made without departing from the protection scope of the present invention. Therefore, although the present invention is described in detail through the foregoing embodiments, the present invention is not limited to the foregoing embodiments, but may also include more other equivalent embodiments as long as they do not depart from the concept of the present invention. The scope of the present invention is subject to the scope of the appended claims.

## Claims

1. A switch on/off circuit for a battery management system, comprising a driving signal input terminal, a start-up driving signal output terminal, a power supply terminal, a power signal extraction circuit, a trigger circuit and a switch;
the driving signal input terminal being connected to the start-up driving signal output terminal by the switch;
the power signal extraction circuit being connected to the power supply terminal, and being configured to output a control signal based on a power signal inputted from the power supply terminal; and
the trigger circuit being electrically connected to the power signal extraction circuit, and being configured to control the switch on or off according to a transition of the control signal.

2. The switch on/off circuit according to claim 1, wherein the power signal extraction circuit comprises a first optocoupler device and a second optocoupler device;
the power supply terminal comprises a power positive terminal and a power negative terminal, the power positive terminal and the power negative terminal are respectively electrically connected to a first terminal and a second terminal of the first optocoupler device, and the power positive terminal and the power negative terminal are respectively electrically connected to a second terminal and a first terminal of the second optocoupler device;
the trigger circuit comprises a first signal trigger terminal and a second signal trigger terminal, a third terminal of the first optocoupler device is electrically connected to the driving signal input terminal and the first signal trigger terminal, a fourth terminal of the first optocoupler device is grounded, and the first optocoupler device is configured to output the control signal for controlling the switch on, and
a third terminal of the second optocoupler device is electrically connected to a high-level signal terminal, a fourth terminal of the second optocoupler device is grounded through a first resistor, the fourth terminal of the second optocoupler device is electrically connected to the second signal trigger terminal, and the second optocoupler device is configured to output the control signal for controlling the switch off.

3. The switch on/off circuit according to claim 2, further comprising a reverse signal output terminal and a first metal-oxide-semiconductor (MOS) transistor, wherein the fourth terminal of the second optocoupler device is electrically connected to a control terminal of the first MOS transistor, a first terminal of the first MOS transistor is electrically connected to the reverse signal output terminal, and a second terminal of the first MOS transistor is grounded.

4. The switch on/off circuit according to claim 2, wherein the trigger circuit comprises a second MOS transistor, a third MOS transistor, a Schmidt trigger, a D-type flip-flop and a fourth MOS transistor;
the third terminal of the first optocoupler device is electrically connected to a control terminal of the second MOS transistor, a first terminal of the second MOS transistor is electrically connected to an input terminal of the Schmidt trigger, and a second terminal of the second MOS transistor is grounded;
the fourth terminal of the second optocoupler device is electrically connected to a control terminal of the third MOS transistor, a first terminal of the third MOS transistor is electrically connected to a reset terminal of the D-type flip-flop, and a second terminal of the third MOS transistor is grounded; and
an output terminal of the D-type flip-flop is electrically connected to a control terminal of the fourth MOS transistor, a first terminal of the fourth MOS transistor is electrically connected to the switch, and a second terminal of the fourth MOS transistor is grounded.

5. The switch on/off circuit according to claim 4, further comprising an auxiliary shutdown circuit, wherein the auxiliary shutdown circuit comprises an input terminal, an output terminal and an auxiliary shutdown signal terminal; and
the input terminal of the auxiliary shutdown circuit is electrically connected to the start-up driving signal output terminal, the output terminal of the auxiliary shutdown circuit is electrically connected to the reset terminal of the D-type flip-flop, and the auxiliary shutdown circuit is configured to output the control signal for controlling the switch off according to a signal inputted from the auxiliary shutdown signal terminal.

6. The switch on/off circuit according to claim 5, wherein the auxiliary shutdown circuit comprises a triode, a third resistor, a first capacitor and a fifth MOS transistor;
a control terminal of the triode is electrically connected to the auxiliary shutdown signal terminal, a first terminal of the triode is electrically connected to the start-up driving signal output terminal, the third resistor is connected in parallel to the first capacitor, a second terminal of the triode is grounded through the third resistor, and the second terminal of the triode is electrically connected to a control terminal of the fifth MOS transistor; and
a first terminal of the fifth MOS transistor is electrically connected to the reset terminal of the D-type flip-flop, and a second terminal of the fifth MOS transistor is grounded.

7. The switch on/off circuit according to claim 6, wherein the auxiliary shutdown circuit further comprises a fourth resistor, a fifth resistor, a sixth resistor and a seventh resistor;
the start-up driving signal output terminal is electrically connected to the first terminal of the triode through the fourth resistor, the start-up driving signal output terminal is electrically connected to the control terminal of the triode through the fifth resistor, the auxiliary shutdown signal terminal is electrically connected to the control terminal of the triode through the sixth resistor, and the second terminal of the triode is electrically connected to the control terminal of the fifth MOS transistor through the seventh resistor.

8. The switch on/off circuit according to claim 2, further comprising an emergency start circuit, wherein the emergency start circuit comprises a key switch, a first terminal of the key switch is grounded, and a second terminal of the key switch is electrically connected to the control terminal of the second MOS transistor.

9. The switch on/off circuit according to claim 8, wherein the second terminal of the key switch is electrically connected to the control terminal of the second MOS transistor through an eighth resistor.

10. The switch on/off circuit according to claim 2, wherein the power positive terminal is electrically connected to the first terminal of the first optocoupler device by a first diode, and the power negative terminal is electrically connected to the first terminal of the second optocoupler device by a second diode;
a third diode is connected in parallel between the power positive terminal and the power negative terminal, and the power positive terminal is electrically connected to the first terminal of the first optocoupler device by a first inductor; and
the power positive terminal is electrically connected to the power negative terminal by a ninth resistor and a tenth resistor, and the power positive terminal is electrically connected to the first terminal of the first optocoupler device by the ninth resistor.
